# FASCICULE DE BREVET EUROPEEN

(11) **EP 0 700 136 B1**
(45) Date de publication et mention de la délivrance du brevet: **24.06.1998**
(21) Numéro de dépôt: 95401951.9
(22) Date de dépôt: 25.08.1995
(51) Int. Cl.: H01S 3/025, H01L 25/16, H01L 33/00, G02B 6/12, G02B 6/42

(54) **Procédé d'alignement d'un ruban enterré et d'un ruban externe dans un composant optique semiconducteur**
Verfahren zur Ausrichtung eines vergrabenen Streifenleiters und eines externen Streifenleiters in einem optischen Halbleiterbauelement
Alignment method of a buried stripe and an external stripe in an optical semiconductor component

(30) Priorité: 31.08.1994 FR 9410502
(43) Date de publication de la demande: 06.03.1996
(73) Titulaire: ALCATEL ALSTHOM COMPAGNIE GENERALE D'ELECTRICITE, 75008 Paris (FR)
(72) Inventeur: Goldstein, Léon, F-92370 Chaville (FR); Vinchant, Jean-François, F-91680 Bruyeres Le Chatel (FR); Leclerc, Denis, F-91430 Igny (FR); Gentner, Jean-Louis, F-91190 Gif-sur-Yvette (FR)
(74) Mandataire: Fournier, Michel

(56) Documents cités:
- GB-A- 2 200 797
- GB-A- 2 237 654
- JOURNAL OF LIGHTWAVE TECHNOLOGY., vol. 5, no. 9, Septembre 1987 NEW YORK US, pages 1277-1285, M.SUZUKI ET.AL. 'Monolithic integration of InGaAsP/InP distributed feedback laser and electroabsorbtion modulator by vapor phase epitaxy'
- PATENT ABSTRACTS OF JAPAN vol. 13 no. 481 (E-838) ,28 Juillet 1989 & JP-A-01 189183 (RICOH CO)
- PATENT ABSTRACTS OF JAPAN vol. 10 no. 32 (E-379) [2089] ,7 Février 1986 & JP-A-60 189279 (NIPPON DENKI)

## Description

La présente invention concerne de manière générale le domaine des circuits photoniques intégrés. Elle concerne plus spécifiquement l'intégration d'un ruban enterré avec un ruban externe au sein d'un même composant semiconducteur. Les rubans enterré et externe constituent typiquement les guides de lumière d'un laser et d'un modulateur intégrés au sein d'un même composant, ce dernier étant constitué par exemple à base de phosphure d'indium. Ils sont respectivement désignés internationalement par les termes anglais "Buried Heterostructure" ou "BH" pour "heterostructure enterrée" et "ridge" pour "arête". Leurs caractéristiques respectives seront rappelées dans la description ci-après.

Un procédé connu pour réaliser une telle intégration est celui du couplage bout à bout appelé internationalement "butt coupling". Il est notamment décrit dans les articles suivants :

M. Suzuki, Y. Noda, H. Tanaka, S. Akiba, Y. Kushiro, and H. Issiki, "Monolithic integration of InGaAsP/InP distributed feedback laser and electroabsorption modulator by vapor phase epitaxy," J. Lightwave technolo., vol. LT-5, pp. 1277-1285, 1987.
- Yuichi TOHMORI and Mauronu OISHI, Japaneses Journal of Applied Physics, vol. 27, n° 4, April 1988 pp L693 - L695

Les performances des composants obtenus par les procédés connus apparaissent insuffisantes notamment quant à l'intensité des faisceaux lumineux modulés susceptibles d'être obtenus. La présente invention a notamment pour but d'améliorer les performances d'un composant intégrant un ruban enterré tel que celui d'un laser et un ruban externe tel que celui d'un modulateur lorsque ces deux rubans doivent être couplés optiquement en série.

Dans ce but elle a pour objet un procédé d'alignement d'un ruban enterré et d'un ruban externe dans un composant optique semiconducteur, ce procédé étant caractérisé par le fait qu'on forme d'abord par gravure une bande de délimitation délimitant en alignement le ruban enterré et le ruban externe et apte à résister à des attaques, puis une première attaque dégage le ruban externe et une amorce de ruban enterré, puis une deuxième attaque dégage le corps du ruban enterré après protection du ruban externe, enfin un dépôt sélectif réalise le confinement latéral du ruban enterré.

Selon la présente invention il est apparu qu'une cause importante de la limitation des performances des composants connus intégrant deux tels rubans résultait de pertes de couplage liées à un alignement imparfait des deux rubans. C'est pourquoi le procédé selon l'invention vise à réaliser avec une précision accrue l'alignement mutuel des deux rubans d'un composant. Une telle précision est obtenue, comme connu en soi pour l'alignement d'autre types de guides, par le fait qu'il s'agit d'un autoalignement, c'est-à-dire que les positions et les orientations des deux rubans sont définies par un même masque au cours de l'étape de gravure qui forme la bande de délimitation.

A l'aide des figures schématiques ci-jointes, on va décrire plus particulièrement ci-après, à titre d'exemple non limitatif, comment la présente invention peut être mise en oeuvre. Lorsqu'un même élément est représenté sur plusieurs figures il y est désigné par le même signe de référence.

La figure 1 représente une vue en coupe longitudinale d'une plaquette semiconductrice dans laquelle un ruban enterré et un ruban externe doivent être formés.

La figure 2 représente une vue de cette plaquette en coupe longitudinale après dépôt d'une couche de délimitation.

La figure 3 représente une vue de dessus de cette plaquette après gravure de la couche de délimitation et une première attaque de la plaquette.

Les figures 4 et 5 représentent deux vues de cette plaquette en coupe selon deux plans transversaux IV-IV et V-V de la figure 3 après cette première attaque.

Les figures 6 et 7 représentent deux vues de cette plaquette en coupe selon les deux mêmes plans transversaux après une deuxième attaque.

La figure 8 représente une vue de cette plaquette en coupe par le plan transversal IV-IV après remplissage d'évidements latéraux.

Les figures 9 et 10 représentent deux vues de cette plaquette en coupe par les deux mêmes plans transversaux après la formation d'électrodes.

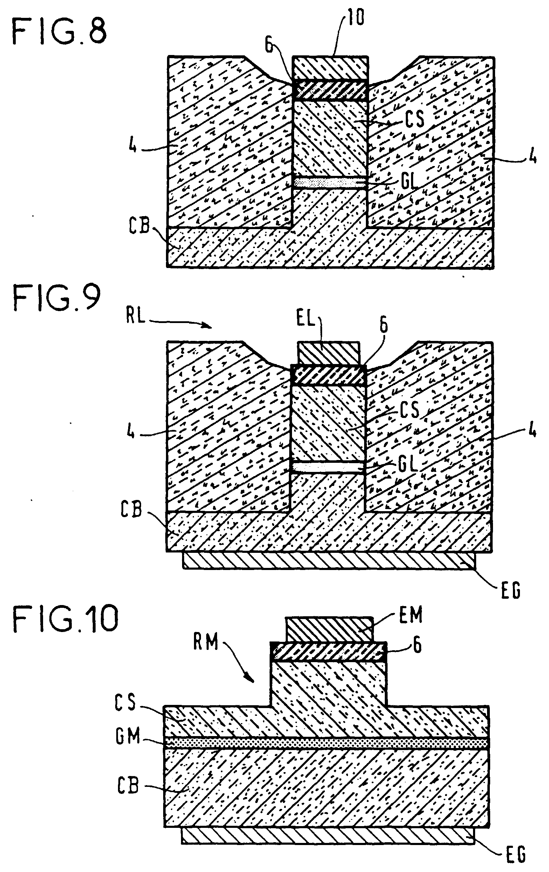

Conformément à ces figures, un composant à fabriquer comporte une plaquette semiconductrice 2 formée de couches s'étendant selon une direction longitudinale DL et une direction transversale DT et superposées selon une direction verticale DV. Ces directions sont définies par rapport à cette plaquette. Cette plaquette comporte un segment à ruban enterré SL et un segment à ruban externe SM s'étendant et se succédant selon la direction longitudinale et comportant respectivement un ruban enterré RL et un ruban externe RM. Ces rubans sont représentés aux figures 9 et 10. Ils sont mutuellement alignés selon la direction DL.

Chacun d'eux comporte une couche à indice accru GL ou GM située entre deux couches de confinement l'une inférieure CB et l'autre supérieure CS. L'indice accru considéré ici est un indice de réfraction et il est accru par rapport à celui des couches de confinement de manière à limiter l'extension verticale d'un mode guidé selon lequel une onde optique doit se propager longitudinalement dans ce ruban.

La couche à indice accru GL et la couche de confinement supérieure CS du ruban enterré RL sont limitées transversalement entre deux blocs de confinement latéral 4 faisant parties de la plaquette 2. Ces blocs ont un indice de réfraction inférieur audit indice accru de manière que cette limitation transversale de la couche à indice accru limite l'extension transversale du mode guidé par ce ruban. Ils sont par ailleurs réalisés de manière à confiner dans le ruban enterré un courant d'alimentation circulant verticalement dans la plaquette. Ceci peut être obtenu de manière connue par un accroissement de la résistivité électrique d'un matériau constitutif de ces blocs, et/ou par la formation d'une jonction semiconductrice bloquante dans ces blocs.

La couche de confinement supérieure CS du ruban externe RM a un indice de réfraction supérieur à celui d'un espace, par exemple gazeux, extérieur à la plaquette. Elle est limitée transversalement entre deux évidements 14 et 16 de la plaquette appartenant à cet espace extérieur et laissant subsister la couche à indice accru GM et la couche de confinement inférieure CB. Cette limitation transversale de la couche de confinement supérieure limite l'extension transversale du mode guidé par ce ruban.

Toutes ces couches ont été formées par des dépôts épitaxiaux sur un substrat non représenté. Ce substrat et la couche de confinement inférieure sont par exemple du type n. La couche de confinement supérieure CS est par exemple du type p de même qu'une couche de contact fortement dopée 6 qui a été déposée sur cette couche de confinement.

Le composant à fabriquer comporte aussi des électrodes EL, EM et EG formées au-dessus et au-dessous de la plaquette dans chacun des segments. Plus précisément les électrodes EL et EM sont respectivement formées sur le ruban enterré RL et sur le ruban externe RL et l'électrode inférieure EG est commune aux deux segments.

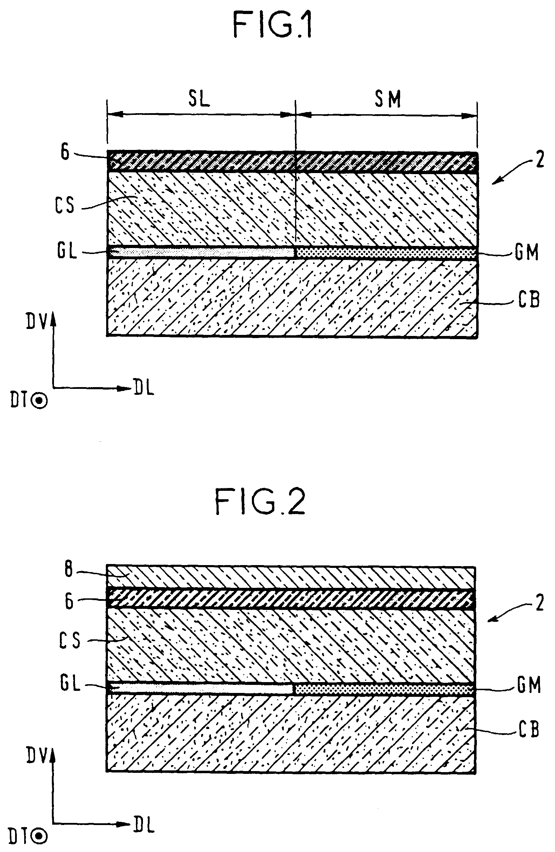

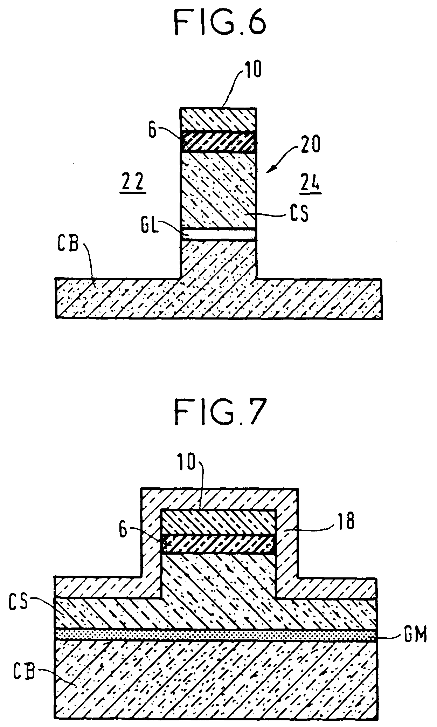

Le procédé de fabrication de ce composant comporte les opérations suivantes connues en elles-mêmes pour former le ruban externe RM :
- dépôt de la couche de confinement inférieure CB, de la couche à indice accru GL, GM, de la couche de confinement supérieure CS et d'une couche de délimitation 8 représentée à la figure 2 et surmontant la couche de confinement supérieure dans les deux segments,
- gravure de cette couche de délimitation pour former dans le segment à ruban externe SM une bande de délimitation 10 coïncidant transversalement avec le ruban externe RM à former,
- et attaque de la plaquette par un milieu d'attaque épargnant la bande de délimitation 10. Cette attaque est limitée en profondeur en déçà de la couche à indice accru GL, GM. Elle fait apparaître deux évidements latéraux initiaux 14 et 16 représentés à la figure 5 et situés de part et d'autre du ruban externe RM. Elle sera désignée ci-après comme étant une première attaque.

Le procédé comporte bien entendu aussi les opérations nécessaires à la formation du ruban enterré et des électrodes.

Dans le procédé connu de couplage bout à bout, on forme d'abord le ruban de l'un des segments, puis on attaque la plaquette dans l'autre segment jusqu'à la couche de confinement inférieure, puis on reforme une structure semiconductrice dans cet autre segment par des dépôts épitaxiaux sélectifs successifs, puis on forme le ruban de cet autre segment par une attaque convenable.

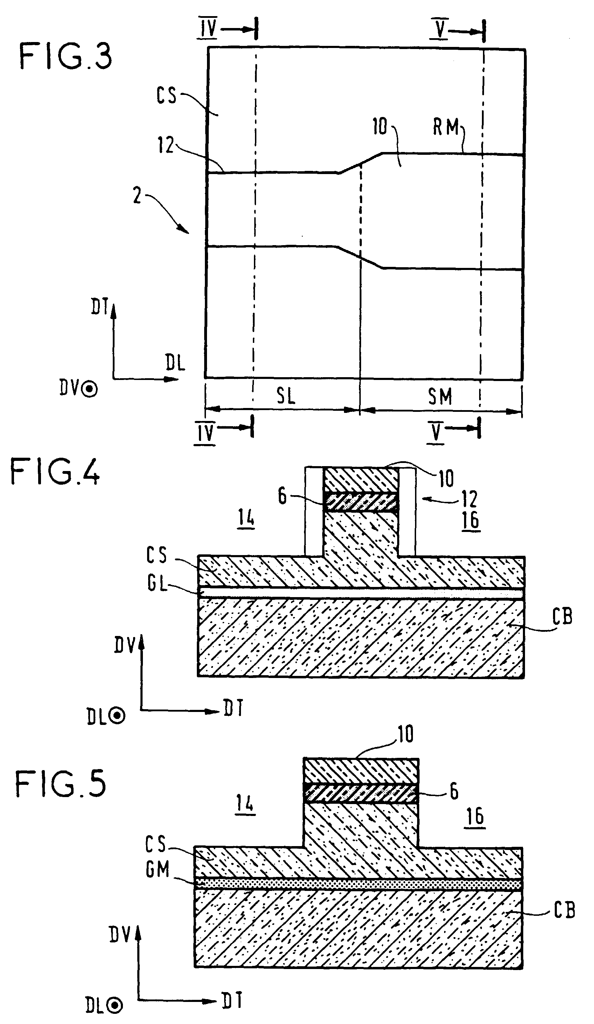

Conformément à la présente invention l'opération de gravure de la couche de délimitation est effectuée pour former aussi la bande de délimitation 10 dans le segment à ruban enterré SL en faisant coïncider transversalement cette bande avec le ruban enterré RL à former. Il en résulte que la première attaque dégage ensuite dans ce premier segment une amorce de ruban enterré 12. Cette amorce est représentés à la figure 4. Elle fait saillie entre les deux évidements latéraux initiaux 14 et 16 qui sont limités en profondeur en deçà de la couche à indice accru GL.

Le procédé selon cette invention comporte ensuite les opérations suivantes pour former le ruban enterré :
- Dépôt d'une couche de protection 18 dans les deux segments SL et SM.
- Gravure de cette couche de protection 18 pour ne la laisser subsister que dans le segment à ruban externe SM.
- Attaque de la plaquette par un milieu d'attaque épargnant la couche de protection. Cette deuxième attaque est poursuivie en profondeur au-delà de la couche à indice accru GL de manière à dégager dans le segment à ruban enterré SL un corps de ruban enterré 20. Ce corps est représenté à la figure 6. Il fait saillie entre deux évidements latéraux approfondis 22 et 24.
- Enfin dépôt sélectif d'au moins un matériau 4 par une méthode de dépôt sélective qui est inefficace sur les parties subsistantes des couches de délimitation 10 et de protection 18. Ce dépôt constitue les blocs de confinement latéral 4 en remplissant lesdits évidements latéraux approfondis.

Bien entendu, selon le type de laser à ruban enterré à réaliser, on peut constituer les blocs de confinement latéral par dépôt d'une succession de matériaux différents les uns des autres.

Les couches de délimitation 10 et de protection 18 sont typiquement constituées de matériaux diélectriques. Le procédé comporte alors en outre une opération d'élimination au moins partielle des parties subsistantes des couches de délimitation et de protection après le dépôt du matériau de confinement latéral 4 et avant la formation des électrodes supérieures EL et EM.

Les couches de confinement CB et CS sont par exemple constituées de phosphure d'indium Inp, la couche à indice accru GL, GM d'alliages ternaires ou quaternaires tels que Ga In AS, Ga In As P, la couche de délimitation 10 de nitrure de silicium Si3N4 et la couche de protection 18 de silice SiO2, au moins un matériau de confinement latéral 4 étant constitué par exemple de phosphure d'indium semiisolant.

Typiquement la couche à indice accru GL, GM présente deux longueurs d'onde caractéristiques différentes respectivement dans les deux dits segments de manière que le segment à ruban enterré SL constitue un laser pour émettre une lumière infrarouge et que le segment à ruban externe SM constitue un modulateur pour moduler cette lumière.

## Revendications

1. Procédé d'alignement d'un ruban enterré et d'un ruban externe dans un composant optique semiconducteur, ce procédé étant caractérisé par le fait qu'on forme d'abord par gravure une bande de délimitation (10) délimitant en alignement le ruban enterré (RL) et le ruban externe (RM) et apte à résister à des attaques, puis une première attaque dégage le ruban externe et une amorce de ruban enterré (12), puis une deuxième attaque dégage le corps du ruban enterré (20) après protection du ruban externe, enfin un dépôt sélectif réalise le confinement latéral du ruban enterré.

2. Procédé selon la revendication 1, un composant à fabriquer devant comporter une plaquette semiconductrice (2) formée de couches s'étendant selon une direction longitudinale (DL) et une direction transversale (DT) de cette plaquette et superposées selon une direction verticale (DV) de cette plaquette, cette plaquette comportant un segment à ruban enterré (SL) et un segment à ruban externe (SM) s'étendant et se succédant selon la direction longitudinale et comportant respectivement un ruban enterré (RL) et un ruban externe (RM) et mutuellement alignés selon cette direction, ces deux rubans comportant chacun une couche à indice accru (GL, GM) située entre deux couches de confinement l'une inférieure (CB) et l'autre supérieure (CH) et ayant un indice de réfraction accru par rapport à ceux de ces couches de confinement de manière à limiter l'extension verticale d'un mode guidé selon lequel une onde optique doit se propager longitudinalement dans ce ruban, la couche à indice accru (GL) et la couche de confinement supérieure (CH) du ruban enterré (RL) étant limitées transversalement entre deux parties de la plaquette constituant deux blocs de confinement latéral (4) ayant un indice de réfraction inférieur audit indice accru de manière que cette limitation transversale de la couche à indice accru limite l'extension transversale du mode guidé par ce ruban, ces blocs étant par ailleurs réalisés de manière à confiner dans le ruban enterré un courant d'alimentation circulant verticalement dans la plaquette, la couche de confinement supérieure (CH) du ruban externe (RM) ayant un indice de réfraction supérieur à celui d'un espace extérieur à la plaquette et étant limitée transversalement entre deux évidements (14, 16) de la plaquette appartenant à cet espace extérieur et laissant subsister la couche à indice accru (GM) et la couche de confinement inférieure (CB) de manière que cette limitation transversale de la couche de confinement supérieure limite l'extension transversale du mode guidé par ce ruban, le composant à fabriquer comportant aussi des électrodes (EL, EM, EG) formées au-dessus et au-dessous de la plaquette dans chacun dans desdits segments, ce procédé comportant les opérations suivantes pour former le ruban externe (RM) :
- dépôt de la couche de confinement inférieure (CB), de la couche à indice accru (GL, GM), de la couche de confinement supérieure (CH) et d'une couche de délimitation (8) surmontant la couche de confinement supérieure dans les deux segments,
- gravure de cette couche de délimitation pour former dans le segment à ruban externe (SM) une bande de délimitation (10) coïncidant transversalement avec le ruban externe (RM) à former,
- et attaque de la plaquette par un milieu d'attaque épargnant la bande de délimitation (10), cette attaque étant limitée en profondeur en déçà de la couche à indice accru (GL, GM) et faisant apparaître deux évidements latéraux initiaux (14, 16) de part et d'autre du ruban externe (RM), cette attaque constituant une première attaque, ce procédé comportant aussi la formation du ruban enterré et des électrodes,
ce procédé étant caractérisé par le fait que l'opération de gravure de la couche de délimitation est effectuée pour former aussi la bande de délimitation (10) dans le segment à ruban enterré (SL) en faisant coïncider transversalement cette bande avec le ruban enterré (RL) à former, grâce à quoi ladite première attaque dégage ensuite dans ce premier segment une amorce de ruban enterré (12) faisant saillie entre les deux évidements latéraux initiaux (14, 16) qui sont limités en profondeur en deçà de la couche à indice accru (GL),
ce procédé comportant ensuite les opérations suivantes pour former le ruban enterré :
- dépôt d'une couche de protection (18) dans les deux segments (SL, SM),
- gravure de cette couche de protection (18) pour ne la laisser subsister que dans le segment à ruban externe (SM),
- attaque de la plaquette par un milieu d'attaque épargnant la couche de protection, cette attaque étant poursuivie en profondeur au-delà de la couche à indice accru (GL) de manière à dégager dans le segment à ruban enterré (SL) un corps de ruban enterré (20) faisant saillie entre deux évidements latéraux approfondis (22, 24) de la plaquette, cette attaque constituant une deuxième attaque,
- et dépôt sélectif d'au moins un matériau (4) par une méthode de dépôt sélective inefficace sur les parties subsistantes des couches de délimitation (10) et de protection (18) pour constituer les blocs de confinement latéral (4) en remplissant lesdits évidements latéraux approfondis.

3. Procédé selon la revendication 2 dans lequel les couches de délimitation (10) et de protection (18) sont constituées de matériaux diélectriques, ce procédé comportant en outre une opération d'élimination au moins partielle des parties subsistantes des couches de délimitation et de protection après le dépôt du matériau de confinement latéral (4) et avant la formation des électrodes supérieures (EL, EM).

4. Procédé selon la revendication 3 dans lequel les couches de confinement (CB, CS) sont constituées de phosphure d'indium InP, la couche à indice accru (GL, GM) d'alliages au moins ternaires, la couche de délimitation (10) de nitrure de silicium Si3N4 et la couche de protection (18) de silice SiO2.

5. Procédé selon la revendication 3 dans lequel la couche à indice accru (GL, GM) présente deux longueurs d'onde caractéristiques différentes respectivement dans les deux dits segments de manière que le segment à ruban enterré (SL) constitue un laser pour émettre une lumière infrarouge et que le segment à ruban externe (SM) constitue un modulateur pour moduler cette lumière.

## Patentansprüche

1. Verfahren zur Ausrichtung eines vergrabenen Streifenleiters und eines externen Streifenleiters in einem optischen Halbleiterbauelement, **dadurch gekennzeichnet,** dass zuerst durch Gravur ein Begrenzungsstreifen (10) gebildet wird, der bei der Ausrichtung den vergrabenen Streifenleiter (RL) und den externen Streifenleiter (RM) begrenzt und geeignet ist, Angriffen zu widerstehen, dann ein erster Angriff den externen Streifenleiter und einen Anfang (12) des vergrabenen Streifenleiters freilegt, dann nach Schutz des externen Streifenleiters ein zweiter Angriff den Körper (20) des vergrabenen Streifenleiters freilegt, schließlich ein selektives Niederlegen den seitlichen Einschluss des vergrabenen Streifenleiters verwirklicht.

2. Verfahren nach Anspruch 1, wobei ein herzustellendes Bauelement eine Halbleiterscheibe (2) aufweisen muss, die aus Schichten ausgebildet ist, die sich entlang einer Längsrichtung (DL) und einer Querrichtung (DT) dieser Scheibe erstrecken und entlang einer vertikalen Richtung (DV) dieser Scheibe übereinandergelegt sind, wobei diese Scheibe ein Segment (SL) mit vergrabenem Streifenleiter und ein Segment (SM) mit externem Streifenleiter aufweist, die sich entlang der Längsrichtung erstrecken und aufeinanderfolgen und einen vergrabenen Streifenleiter (RL) bzw. einen externen Streifenleiter (RM) aufweisen und entlang dieser Richtung gegenseitig aqsgerichtet sind, wobei diese Streifenleiter jeweils eine Schicht (GL, GM) mit erhöhtem Index aufweisen, die sich zwischen zwei Einschlussschichten, der einen unteren (CB) und der anderen oberen (CH), befinden und einen erhöhten Brechungsindex haben, der im Vergleich mit denen dieser Einschlussschichten erhöht ist, um die vertikale Ausdehnung eines geleiteten Modus zu begrenzen, gemäß dem eine optische Welle sich in diesem Streifenleiter in Längsrichtung ausbreiten muss, wobei die Schicht (GL) mit erhöhtem Index und die obere Einschlussschicht (CH) des vergrabenen Streifenleiters (RL) in Querrichtung zwischen zwei Teilen der Scheibe begrenzt sind, die zwei Blöcke (4) zum seitlichen Einschluss bilden, die einen Brechungsindex haben, der geringer als der erhöhte Index ist, so dass diese Querbegrenzung der Schicht mit erhöhtem Index die Querausdehnung des durch den Streifenleiter geleiteten Modus begrenzt, wobei diese Blöcke außerdem so ausgeführt sind, dass in dem vergrabenen Streifenleiter ein Versorgungsstrom eingeschlossen wird, der in der Scheibe vertikal zirkuliert, wobei die obere Einschlussschicht (CH) des externen Streifenleiters (RM) einen Brechungsindex hat, der größer als der eines Raumes außerhalb der Scheibe ist, und in Querrichtung zwischen zwei Aussparungen (14, 16) der Scheibe begrenzt ist, die zu diesem äußeren Raum gehören und die Schicht (GM) mit erhöhtem Index und die untere Einschlussschicht (CB) stehen lassen, so dass diese Querbegrenzung der oberen Einschlussschicht die Ausdehnung in Querrichtung des von diesem Streifenleiter geleiteten Modus ist, wobei das herzustellende Bauelement auch Elektroden (EL, EM, EG) aufweist, die über und unter der Scheibe in jedem der Segmente ausgebildet sind, wobei das Verfahren die folgenden Arbeitsgänge zur Ausbildung des externen Streifenleiters (RM) umfasst:
- Niederlegen der unteren Einschlussschicht (CB), der Schichp (GL, GM) mit erhöhtem Index, der oberen Einschlussschicht (CH) und einer Begrenzungsschicht (8), die die obere Einschlussschicht in den beiden Segmenten überragt,
- Ätzen dieser Begrenzungsschicht, um in dem Segment (SM) mit externem Streifenleiter einen Begrenzungsstreifen (10) auszubilden, der in Querrichtung mit dem auszubildenden externen Streifenleiter (RM) zusammenfällt,
- und Angriff auf die Scheibe durch ein Angriffsmittel, das den Begrenzungsstreifen (10) verschont, wobei dieser Angriff in der Tiefe diesseits der Schicht (GL, GM) mit erhöhtem Index begrenzt ist und zwei seitliche Anfangsaussparungen (14, 16) beiderseits des externen Streifenleiters (RM) erscheinen lässt, wobei dieser Angriff einen ersten Angriff bildet, wobei dieses Verfahren auch die Ausbildung des vergrabenen Streifenleiters und der Elektroden umfasst,
dadurch gekennzeichnet, dass der Gravurarbeitsgang der Begrenzungsschicht so ausgeführt wird, dass auch der Begrenzungsstreifen (10) in dem Segment (SL) mit vergrabenem Streifenleiter ausgebildet wird, wobei dieser Streifen mit dem auszubildenden vergrabenen Streifenleiter (RL) in Querrichtung zusammenfallen gelassen wird, aufgrund dessen der erste Angriff dann in diesem ersten Segment einen Anfang (12) des vergrabenen Streifenleiters freilegt, der zwischen den beiden seitlichen Anfangsaussparungen (14, 16) hervortritt, die in der Tiefe diesseits der Schicht (GL) mit erhöhtem Index begrenzt sind, wobei das Verfahren dann die folgenden Arbeitsvorgänge zur Ausbildung des vergrabenen Streifenleiters umfasst:
- Niederlegen einer Schutzschicht (18) in den beiden Segmenten (SL, SM),
- Gravur dieser Schutzschicht (18), um sie nur in dem Segment (SM) mit externem Streifenleiter stehen zu lassen,
- Angriff auf die Scheibe durch ein Angriffsmittel, das die Schutzschicht verschont, wobei dieser Angriff in der Tiefe jenseits der Schicht (GL) mit erhöhtem Index fortgesetzt wird, um in dem Segment (SL) mit vergrabenem Streifenleiter einen Körper (20) des vergrabenen Streifenleiters freizulegen, der zwischen zwei vertieften seitlichen Aussparungen (22, 24) der Scheibe hervortritt, wobei dieser Angriff einen zweiten Angriff bildet,
- und selektives Niederlegen wenigstens eines Materials (4) durch eine selektive Niederlegungsmethode, die auf den vorhandenen Teilen der Begrenzungs- (10) und Schutzschichten (18) unwirksam ist, um die Blöcke (4) zum seitlichen Einschluss auszubilden, indem die vertieften seitlichen Aussparungen ausgefüllt werden.

3. Verfahren nach Anspruch 2, bei dem die Begrenzungs-(10) und Schutzschichten (18) aus dielektrischen Materialien bestehen, wobei das Verfahren außerdem einen Arbeitsgang des wenigstens teilweisen Entfernens der vorhandenen Teile der Begrenzungs- und Schutzschichten nach dem Niederlegen des Materials (4) für den seitlichen Einschluss und vor der Ausbildung der oberen Elektroden (EL, EM) umfasst.

4. Verfahren nach Anspruch 3, bei dem die Einschlussschichten (CB, CS) aus Indiumphosphid InP, die Schicht (GL, GM) mit erhöhtem Index aus wenigstens ternären Legierungen, die Begrenzungsschicht (10) aus Siliciumnitrid Si₃N₄ und die Schutzschicht (18) aus Siliciumdioxid SiO₂ bestehen.

5. Verfahren nach Anspruch 3, bei dem die Schicht (GL, GM) mit erhöhtem Index jeweils zwei verschiedene charakteristische Wellenlängen in den beiden Segmenten aufweist, so dass das Segment (SL) mit vergrabenem Streifenleiter einen Laser zum Aussenden eines infraroten Lichts bildet und dass das Segment (SM) mit externem Streifenleiter einen Modulator zum Modulieren dieses Lichts bildet.

## Claims

1. Method of aligning a buried heterostructure and a ridge in a semiconductor optical component, characterised in that a delimiter stripe (10) is etched to delimit the buried heterostructure (RL) and the ridge (RM) aligned with each other and adapted to resist etching, after which a first etch uncovers the ridge and a buried heterostructure precursor (12), after which a second etch uncovers the body of the buried heterostructure (20) following protection of the ridge, and finally lateral cladding of the buried heterostructure is selectively deposited.

2. Method according to claim 1 wherein, when a component to be fabricated has to include a semiconductor wafer (2) in the form of layers extending in a longitudinal direction (DL) and a transverse direction (DT) of the wafer and stacked in a vertical direction (DV) of the wafer, the wafer including a buried heterostructure segment (SL) and a ridge segment (SM) extending in succession along the longitudinal direction and respectively including a buried heterostructure (RL) and a ridge (RM) aligned with each other in the direction, the buried heterostructure and the ridge each including an increased index layer (GL, GM) between top and bottom cladding layers (CB, CS) and having an increased refractive index compared to the cladding layers so as to limit the vertical extent of a guided mode with which an optical wave is to propagate longitudinally in the buried heterostructure or stripe, the increased index layer (GL) and the top cladding layer (CS) of the buried heterostructure (RL) being delimited transversely between two parts of the wafer constituting two lateral cladding blocks (4) having a refractive index lower than the increased index so that the transverse limitation of the increased index layer limits the transverse extent of the mode guided by the buried heterostructure or stripe, the blocks being adapted to confine within the buried heterostructure a supply current flowing vertically in the wafer, the top cladding layer (CS) of the ridge (RM) having a refractive index higher than that of a space external to the wafer and being delimited transversely between two recesses (14, 16) in the wafer forming part of the exterior space and leaving the increased index layer (GM) and the bottom cladding layer (CB) so that the transverse limitation of the top cladding layer delimits the transverse extent of the mode guided by the buried heterostructure or ridge, the component to be fabricated also including electrodes (EL, EM, EG) formed on the top of and on the bottom of the wafer in each of said segments, the method including the following operations to form the ridge (RM):
- depositing the bottom cladding layer (CB), the increased index layer (GL, GM), the top cladding layer (CS) and a delimiter layer (8) on top of the top cladding layer in both segments,
- etching the delimiter layer to form in the ridge segment (SM) a delimiter stripe (10) registering transversely with the ridge (RM) to be formed, and
- etching the wafer using an etch medium that does not etch the delimiter stripe (10), the etch stopping short of the increased index layer (GL, GM) and uncovering two initial lateral recesses (14, 16) one on each side of the ridge (RM), the etch constituting a first etch, the method also including the formation of a buried heterostructure and electrodes,
the method being characterised in that the operation to etch the delimiter layer also forms the delimiter stripe (10) in the buried heterostructure segment (SL) registering transversely with the buried heterostructure (RL) to be formed, whereby said first etch thereafter uncovers in the first segment a buried heterostructure precursor (12) projecting between the two initial lateral recesses (14, 16) that are not as deep as the increased index layer (GL),
the method then including the following steps to form the buried heterostructure:
- depositing a protection layer (18) in both segments (SL, SM),
- etching the protection layer (18) so that it remains only in the ridge segment (SM),
- etching the wafer using an etch medium that does not etch the protection layer, this etch being continued to a depth beyond the increased index layer (GL) so as to uncover in the buried heterostructure segment (SL) a buried heterostructure body (20) projecting between two deep lateral recesses (22, 24) in the wafer, this etch constituting a second etch, and
- selectively depositing at least one material (4) by a method that is without effect on the remaining parts of the delimiter and protection layers (10, 18) to constitute the lateral cladding blocks (4) by infilling said deep lateral recesses.

3. Method according to claim 2 wherein the delimiter and protection layers (10, 18) are made of dielectric materials, the method further including an operation to eliminate at least part of the remaining portions of the delimiter and protection layers after depositing the lateral cladding material (4) and before forming the top electrodes (EL, EM).

4. Method according to claim 3 wherein the cladding layers (CB, CS) are of indium phosphide InP, the increased index layer (GL, GM) of at least ternary alloys, the delimiter layer (10) of silicon nitride Si₃N₄ and the protection layer (18) of silica SiO₂.

5. Method according to claim 3 wherein the increased index layer (GL, GM) has respective different characteristic wavelengths in said two segments so that the buried heterostructure segment (SL) constitutes a laser emitting infrared light and the ridge segment (SM) constitutes a modulator for modulating that light.
